# EUROPÄISCHE PATENTSCHRIFT

(11) **EP 3 754 344 B1**
(45) Veröffentlichungstag und Bekanntmachung des Hinweises auf die Patenterteilung: **10.05.2023**
(21) Anmeldenummer: 20184018.8
(22) Anmeldetag: 15.09.2011
(51) Int. Cl.: G01R 15/20, G01R 15/18, G01R 19/20

(54) **STROMSENSOR**
CURRENT SENSOR
CAPTEUR DE COURANT

(30) Priorität: 01.10.2010 CH 16022010
(43) Veröffentlichungstag der Anmeldung: 23.12.2020
(62) Teilanmeldung aus: 11181474.5
(73) Patentinhaber: Melexis Technologies NV, 3980 Tessenderlo (BE)
(72) Erfinder: RACZ, Robert, 6300 Zug (CH)
(74) Vertreter: Jacobs, Lambert

(56) Entgegenhaltungen:
- US-A1- 2006 033 487
- US-A1- 2006 219 436
- US-A1- 2007 164 727
- US-A1- 2010 156 394
- US-B1- 6 356 068
- US-B2- 7 375 507

## Beschreibung

Die Erfindung betrifft einen Stromsensor der im Oberbegriff des Anspruchs 1 genannten Art.

Stromsensoren gibt es in vielen Ausführungen und Varianten. Stromsensoren, die das vom Strom erzeugte Magnetfeld erfassen, in einem herkömmlichen IC Gehäuse verpackt sind und bei denen der Stromleiter, durch den der zu messende Strom fliesst, durch das Gehäuse geführt ist, sind beispielsweise bekannt aus EP 1443332, WO 2005026749, WO 2006130393, DE 102009054892 und US 6356068.

Aus US 7375507 ist eine Baugruppe zur Strommessung bekannt, die ein Leiterblech mit drei Schlitzen aufweist, dank denen zwei parallel angeordnete Leiterabschnitte gebildet werden, in denen der zu messende Strom in entgegengesetzter Richtung fliesst, und zwei Magnetfeldsensoren umfasst. Die beiden Magnetfeldsensoren sind oberhalb je eines der beiden Leiterabschnitte angeordnet, wo sie das parallel zur Oberfläche des Leiterblechs verlaufende Magnetfeld erfassen.

Der Erfindung liegt die Aufgabe zugrunde, die Frequenzabhängigkeit der Magnetfeldsensoren des Stromsensors zu verbessern.

Die genannte Aufgabe wird erfindungsgemäss gelöst durch die Merkmale des Anspruchs 1. Vorteilhafte Ausgestaltungen ergeben sich aus den abhängigen Ansprüchen.

Die Erfindung wird nachfolgend anhand von Ausführungsbeispielen und anhand der Zeichnung näher erläutert. Die Figuren sind nicht massstäblich gezeichnet.
- Fig. 1: zeigt in Aufsicht einen Stromsensor gemäss einem ersten Ausführungsbeispiel, der auf einer unterbrochenen Leiterbahn einer Leiterplatte montiert ist,
- Fig. 2: zeigt den Stromsensor im Querschnitt entlang der Linie I-I der Fig. 1,
- Fig. 3: zeigt in Aufsicht eine weitere Leiterplatte und einen darauf montierten Stromsensor,
- Fig. 4: zeigt eine Vorrichtung zur Strommessung mit einer Leiterplatte und einem darauf montierten Stromsensor im Querschnitt,
- Fig. 5: zeigt einen Stromleiter und Magnetfeldsensoren des Stromsensors im Querschnitt,
- Fig. 6: zeigt ein Diagramm mit Simulationsergebnissen,
- Fig. 7: zeigt in Aufsicht ein Detail des Stromleiters des Stromsensors und der Leiterbahnen der Leiterplatte, und
- Fig. 8: den Stromsensor der Fig. 1 mit einer anderen Ausführung des Stromleiters.

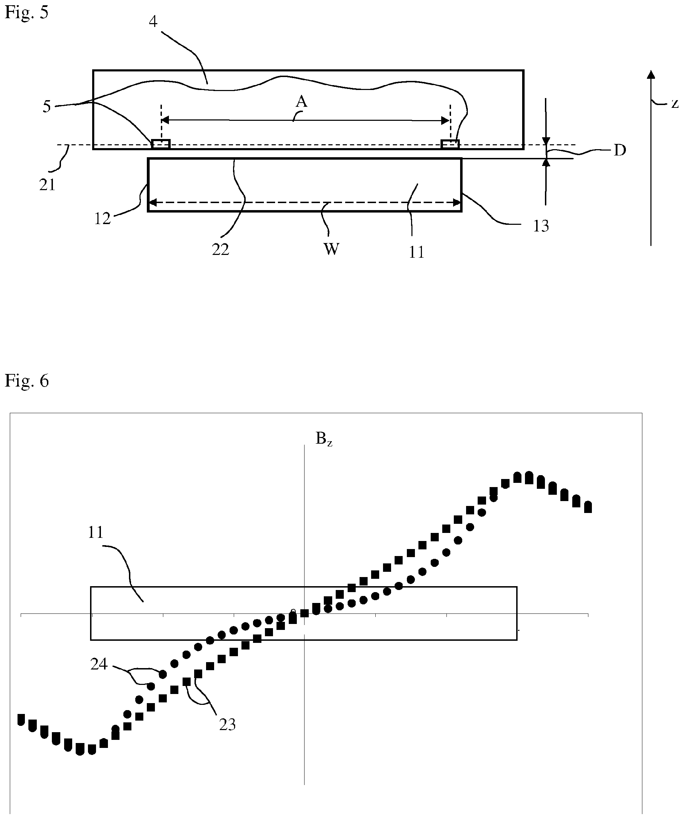

Die Erfindung betrifft die Positionierung der Magnetfeldsensoren eines in einem IC Gehäuse verpackten Stromsensors in Bezug auf den Stromleiter, wie dies weiter unten anhand der Fig. 5 und 6 dargestellt und beschrieben ist.

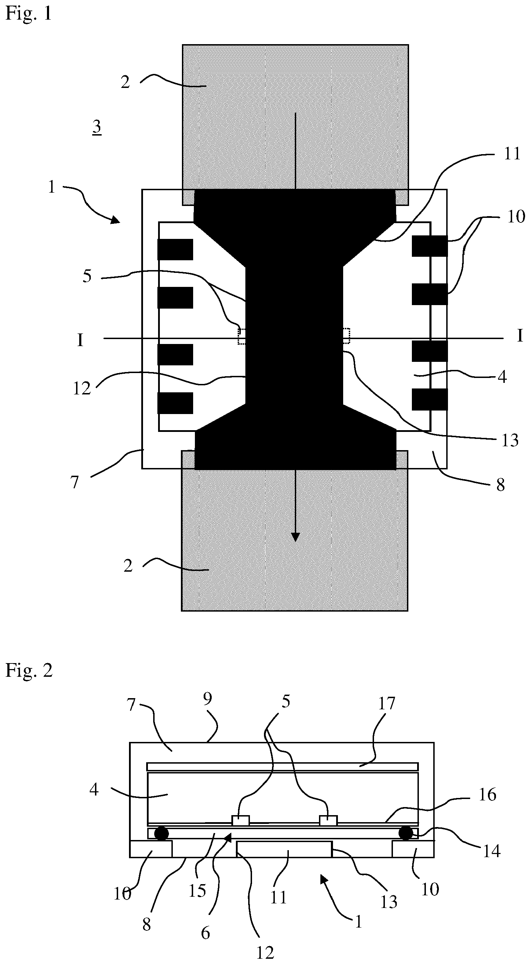

Die Fig. 1 zeigt in Aufsicht einen Stromsensor 1, der bei diesem Beispiel auf einer unterbrochenen Leiterbahn 2 einer Leiterplatte 3 (deren Umriss hier nicht gezeichnet ist) montiert ist. Die Fig. 2 zeigt den Stromsensor 1 in einem Schnitt entlang der Linie I-I der Fig. 1. Die einzelnen Elemente sind in diesen Figuren der besseren Verständlichkeit wegen nicht massstäblich dargestellt. Der Stromsensor 1 kann auch auf einer nicht unterbrochenen, durchgehenden Leiterbahn 2 der Leiterplatte 3 oder einem beliebigen Stromleiter montiert werden und wirkt in diesem Fall als Nebenschlusswiderstand (engl. Shunt), was die Messung grösserer Ströme ermöglicht. Der Stromsensor 1 umfasst einen Halbleiterchip 4 mit zwei Magnetfeldsensoren 5 und elektronischen Schaltkreisen für den Betrieb der Magnetfeldsensoren 5. Die Magnetfeldsensoren 5 sind in die aktive Oberfläche 6 des Halbleiterchips 4 integriert oder auf der Oberfläche 6 des Halbleiterchips 4 angebracht.

Der Stromsensor 1 umfasst weiter ein flaches Gehäuse 7 aus Kunststoff mit einer Unterseite 8 und einer Oberseite 9, die einander gegenüberliegen, und vier Seitenwände. Die Unterseite 8 enthält mindestens drei elektrische Anschlüsse 10 und einen flachen Stromleiter 11, von denen zumindest der Stromleiter 11, vorzugsweise auch die elektrischen Anschlüsse 10, plan in die Unterseite 8 des Gehäuses 7 eingebettet sind und an der Unterseite 8 des Gehäuses 7 freiliegen. Der Stromleiter 11 erstreckt sich bis an zwei einander gegenüberliegende Seitenwände des Gehäuses 7 und ist im Bereich der Magnetfeldsensoren 5 mit Vorteil verjüngt und/oder mit orthogonal zur Stromrichtung verlaufenden Schlitzen versehen, oberhalb derer die Magnetfeldsensoren 5 angeordnet sind. Die elektrischen Anschlüsse 10 sind entlang der beiden anderen Seitenwände angeordnet. Das Gehäuse 7 ist eine durch Vergiessen, im Fachjargon "Molding" genannt, hergestellte Kunststoffummantelung. Das Gehäuse 7 wird als oberflächenmontierbares Bauteil auf die Leiterplatte 3 gelötet, wobei die elektrischen Anschlüsse 10 mit entsprechenden Anschlüssen auf der Leiterplatte 3 und der Stromleiter 11 mit den einander gegenüberliegenden Enden der Leiterbahn 2 verbunden werden. Die Länge des Unterbruchs in der Leiterbahn 2 ist so bemessen, dass die Enden der Leiterbahn 2 und der Stromleiter 11 überlappen und einwandfrei verlötet werden können. Das Gehäuse 7 ist beispielsweise ein sogenanntes QFN Gehäuse. QFN ist ein Akronym für "Quad Flat No leads package". QFN Gehäuse werden in der Fachwelt auch als MLF oder MLP Gehäuse bezeichnet, wobei MLF ein Akronym für "Micro Lead Frame" und MLP ein Akronym für "Micro Lead Package" ist. Der Stromleiter 11 und die elektrischen Anschlüsse 10 sind aus einem sogenannten Leadframe gebildet, d.h. einem strukturierten Rahmen aus Metall, insbesondere Kupfer. Der Stromleiter 11 und die elektrischen Anschlüsse 10 haben die gleiche Dicke, da sie aus dem gleichen Leadframe gebildet sind. Die Dicke des Leadframes beträgt typischerweise 0.2 mm, sie kann aber auch erhöht werden, beispielsweise auf 0.3 mm oder 0.4 mm oder mehr, um damit den elektrischen Widerstand des Stromleiters 11 und somit auch die Verlustwärme zu reduzieren. Der Stromleiter 11 und die elektrischen Anschlüsse 10 liegen auch in der gleichen Ebene, da sie an der Unterseite 8 des Gehäuses 7 freiliegen. Die Enden des Stromleiters 11 sind so breit wie möglich, d.h. sie sind etwa so breit wie die Breite der Gesamtheit der elektrischen Anschlüsse 10, die an einer Seitenwand des Gehäuses 7 Platz finden. Standard QFN Gehäuse gibt es mit einer Anzahl m von elektrischen Anschlüssen 10 pro Seitenwand, d.h. insgesamt 4∗m Anschlüssen pro Gehäuse. Bei einem QFN Gehäuse mit m=3 elektrischen Anschlüssen 10 pro Seitenwand erstrecken sich die Enden des Stromleiters 11 also über eine Breite, die so gross ist, dass auf dem gleichen Platz drei elektrische Anschlüsse 10 Platz finden würden. Es gibt auch QFN Gehäuse mit n∗m elektrischen Anschlüssen 10 mit n≠m, z.B. 3∗4, 4∗5, etc. Hier sind die Enden des Stromleiters 11 dann etwa so breit wie die Gesamtheit der elektrischen Anschlüsse 10, die an der Seitenwand, die die Enden des Stromleiters 11 aufnimmt, Platz finden.

Die Magnetfeldsensoren 5 messen eine Komponente des Magnetfeldes, das von dem durch die Leiterbahn 2 fliessenden Strom erzeugt wird. Die Richtung des durch die Leiterbahn 2 und den Stromsensor 1 fliessenden Stroms ist durch einen Pfeil dargestellt. Die Magnetfeldsensoren 5 sind Magnetfeldsensoren, die empfindlich sind auf diejenige Komponente des Magnetfeldes, die senkrecht zur aktiven Oberfläche 6 des Halbleiterchips 4 verläuft, beispielsweise sogenannte horizontale Hallelemente. Die Magnetfeldsensoren 5 sind - in Richtung des durch den Stromleiter 11 fliessenden Stroms gesehen - im Bereich der Seitenkanten 12 und 13 des Stromleiters 11 angeordnet, so dass die Komponente des Magnetfeldes, die von den Magnetfeldsensoren 5 erfasst wird, an den Orten der beiden Magnetfeldsensoren 5 in entgegengesetzte Richtungen zeigt. Die Ausgangssignale der beiden Magnetfeldsensoren 5 werden voneinander subtrahiert. Durch diese Differenzbildung wird der Einfluss eines äusseren magnetischen Störfeldes weitgehend eliminiert.

Der Halbleiterchip 4 ist in Flipchip Bauweise, d.h. mit seiner aktiven Oberfläche 6 nach unten zeigend, über sogenannte "solder bumps" 14 mit den elektrischen Anschlüssen 10 verbunden, mit dem Vorteil, dass sich die Magnetfeldsensoren 5 in unmittelbarer Nähe des Stromleiters 11 befinden, durch den der zu messende Strom fliesst. Die aktive Oberfläche 6 des Halbleiterchips 4 und der Stromleiter 11 sind durch eine Isolationsschicht 15 getrennt, um eine bestimmte Durchschlagfestigkeit gegen elektrische Spannungsdurchschläge zu erreichen. Wenn die Leiterbahn 2 an ein Netz mit 230 V angeschlossen ist, dann wird typischerweise eine Durchschlagfestigkeit von 2.5 kV verlangt. Dies kann beispielsweise erreicht werden durch eine aus Polyimid gebildete Isolationsschicht 15, die 10 µm dick ist. Die Isolationsschicht 15 kann beispielsweise vor dem Vergiessen auf den Halbleiterchip 4 aufgebracht werden oder sie kann als sogenannte Underfill-Schicht während des Vergiessens aus dem Kunststoffmaterial des Gehäuses 7 gebildet werden.

Um eine effiziente Abschirmung gegen äussere elektrische Einflüsse zu erreichen, ist auf dem Halbleiterchip 4 mit Vorteil eine elektrisch leitende Schicht 16 angebracht, die mit der elektrischen Masse der elektronischen Schaltkreise verbunden ist. Die Schicht 16 kann Schlitze und/oder Ausnehmungen enthalten, um die Entstehung von Wirbelströmen zu verringern. Für die Schicht 16 kann eine Metallisierungsebene des Halbleiterchips 4 verwendet werden, sofern eine freie, nicht anderweitig benötigte Metallisierungsebene zur Verfügung steht. Falls dies nicht der Fall ist, kann die Schicht 16 mit entsprechenden Ausnehmungen für die elektrischen Kontakte zu den Anschlüssen 10 auf der Oberfläche 6 des Halbleiterchips 4 aufgebracht werden.

Zur Verstärkung des von dem durch den Stromleiter 11 fliessenden Strom erzeugten Magnetfelds und als Abschirmung gegen äussere Magnetfelder ist auf der Rückseite des Halbleiterchips 4 mit Vorteil eine Schicht 17 aus ferromagnetischem Material aufgebracht, deren relative Permeabilität wenigstens 1000 beträgt. Die Schicht 17 kann während der Herstellung des Halbleiterchips 4 beispielsweise durch Electroplating oder in Form einer Folie auf die Rückseite des Wafers aufgebracht werden. Die Schicht 16 muss so dick sein, dass sie durch das Magnetfeld, das von dem im Maximum durch den Stromleiter 11 fliessenden Strom erzeugt wird, magnetisch nicht in Sättigung kommt. Um dies zu erreichen, reicht üblicherweise eine Schichtdicke von einigen 10 µm aus.

Der Stromsensor 1 ist ein oberflächenmontierbares Bauteil, das sich von herkömmlichen Stromsensoren in IC Gehäusen dadurch unterscheidet, dass der Stromleiter 11, durch den der zu messende Strom fliesst, an einer Aussenseite des Gehäuses 7, hier der Unterseite 8, freiliegt. Dies ermöglicht es, die im Stromleiter 11 vom Strom erzeugte Verlustwärme auf effiziente Weise an die Umgebung abzugeben.

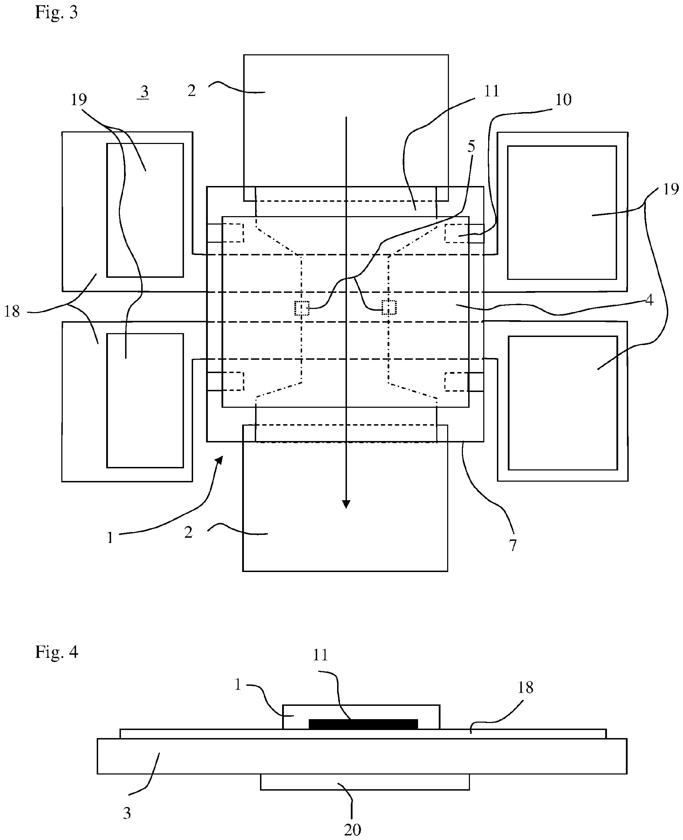

Wie bereits erwähnt, kann der Stromsensor 1 eingesetzt werden, um den durch die Leiterbahn 2 einer Leiterplatte 3 fliessenden Strom zu messen. Der Stromleiter 11 des Stromsensors 1 verbindet dann die Enden der unterbrochenen Leiterbahn 11. Die Leiterplatte 3 und der Stromsensor 1 bilden dann zusammen eine Vorrichtung zur Strommessung. Die Fig. 3 zeigt in Aufsicht ein Ausführungsbeispiel einer Leiterplatte 3 (deren Umriss hier wiederum nicht gezeichnet ist), die eine oder mehrere metallische Flächen 18 aufweist, die gemäss dem hier gezeigten Ausführungsbeispiel bei der Montage des Stromsensors 1 mit dem Stromleiter 11 des Stromsensors 1 verlötet werden. Die Flächen 18 können alternativ oder zusätzlich auch direkt mit den gegenüberliegenden Enden der Leiterbahn 2 verbunden sein. Die Flächen 18 erstrecken sich seitlich über das Gehäuse 7 des Stromsensors 1 hinaus und sind elektrisch freischwebend. Die Flächen 18 dienen dazu, die im Stromleiter 11 erzeugte Verlustwärme noch effizienter an die Umgebung abzuführen. Die geometrische Form der Flächen 18 ist so gestaltet, dass die Flächen 18 keinen Bypass ergeben, durch die ein Teil des Stroms fliessen könnte, so dass der ganze Strom durch den Abschnitt des Stromleiters 11 fliesst, bei dem die beiden Magnetfeldsensoren 5 platziert sind. Die Leiterbahnen der Leiterplatte 3, die die elektrischen Anschlüsse 10 des Stromsensors 1 kontaktieren, sind aus Gründen der zeichnerischen Klarheit nicht dargestellt. Die Flächen 18 sind bevorzugt auf der dem Stromsensor 1 zugewandten Seite der Leiterplatte 3, d.h. ihrer Oberseite, angeordnet, sie können aber auch auf der Unterseite der Leiterplatte 3 angeordnet und mit Durchkontaktierungen zum direkten Verlöten mit dem Stromleiter 11 ausgebildet sein.

Bei dem in der Fig. 3 gezeigten Ausführungsbeispiel sind nur vier elektrische Anschlüsse 10 vorhanden und die Flächen 18 und die Anschlüsse 10 überlappen nicht. Falls wie bei dem in der Fig. 1 gezeigten Ausführungsbeispiel die Anschlüsse 10 relativ viel Platz benötigen, dann können die Flächen 18 auch so gestaltet sein, dass sie mit einigen oder allen der Anschlüsse 10 überlappen. In diesem Fall sind die Flächen 18 mit Ausnehmungen zu versehen, die die Anschlüsse 10 freihalten, so dass bei der Montage des Stromsensors 1 auf der Leiterplatte 3 kein elektrischer Kontakt zwischen den Flächen 18 und den Anschlüssen 10 entsteht. Des weiteren muss die Leiterplatte 3 in diesem Fall mindestens zwei Metallisierungsebenen enthalten.

Auf die Flächen 18 kann bei der Bestückung der Leiterplatte 3 ein oberflächenmontierbares Bauteil 19 aufgebracht werden, das aufgrund seiner dreidimensionalen Form die Abfuhr der Wärme weiter verbessert. Das Bauteil 19 kann ein Kühlkörper, ein Ferrit-Bauteil oder auch ein Widerstand oder ein Kondensator sein. Ein Ferrit-Bauteil wirkt zusätzlich als Abschirmung, die den Stromsensor 1 gegen externe Magnetfelder abschirmt. Vom Kondensator und vom Widerstand ist mindestens ein Kontakt mit der Fläche 18 verlötet.

Die Fig. 4 zeigt im Querschnitt eine Vorrichtung zur Strommessung, bei der auf der Leiterplatte 3 auf der dem Stromsensor 1 abgewandten Seite eine magnetische Abschirmung 20 montiert ist. Die Abschirmung 20 besteht beispielsweise aus Ferrit und ist bevorzugt ebenfalls als oberflächenmontierbares Bauteil ausgebildet. Die Abschirmung 20 verstärkt zudem die Ausgangssignale der Magnetfeldsensoren 5.

Der räumliche Verlauf, d.h. Stärke und Richtung, des Magnetfeldes, das von dem durch den Stromleiter fliessenden Strom erzeugt wird, ist abhängig von der Frequenz des Stroms. Die Fig. 5 zeigt den Stromleiter 11 und den Halbleiterchip 4 mit den beiden Magnetfeldsensoren 5 gemäss dem Aufbau der Fig. 1 im Querschnitt. Die Fig. 6 zeigt die Stärke der senkrecht zur aktiven Oberfläche 6 des Halbleiterchips 4 verlaufenden Komponente B_{z} des Magnetfeldes in einer Ebene 21, die im Abstand D parallel zu der dem Halbleiterchip 4 zugewandten Flachseite 22 des Stromleiters 11 verläuft, die berechnet wurden für einen Stromleiter 11 mit einer Breite W = 1.5 mm und einen Abstand D = 0.3 mm. Die viereckigen Punkte 23 illustrieren die Stärke der Komponente B_{z} des Magnetfeldes, das von einem Gleichstrom erzeugt wird. Die runden Punkte 24 illustrieren die Stärke der Komponente B_{z} des Magnetfeldes, das von einem Wechselstrom mit einer Frequenz von 100 kHz erzeugt wird. Die Lage der Seitenkanten 12 und 13 des Stromleiters 11 ist mit gestrichelten Linien dargestellt. Die Lage des Stromleiters 11 ist ebenfalls eingezeichnet. Aus diesem Diagramm ergeben sich folgende Kriterien für die erfindungsgemässe Positionierung der Magnetfeldsensoren 5 in Bezug auf den Stromleiter 11:
a) Die Frequenzabhängigkeit der Magnetfeldsensoren 5 ist am geringsten, wenn die beiden Magnetfeldsensoren 5 unterhalb der Seitenkanten 12 und 13 des Stromleiters 11 angeordnet sind.
b) Die Empfindlichkeit des aus den beiden Magnetfeldsensoren 5 gebildeten Differenzsignals in Bezug auf eine Verschiebung des Halbleiterchips 4 aus seiner Solllage in x-Richtung ist am geringsten, wenn die beiden Magnetfeldsensoren 5 dort platziert werden, wo die Änderung der Stärke der Komponente B_{z} des Magnetfeldes zumindest stückweise einen möglichst linearen Verlauf hat. Dies ist der Fall, wenn die beiden Magnetfeldsensoren 5 im Bereich zwischen den Seitenkanten 12 und 13 des Stromleiters 11 angeordnet werden.

Da der Stromleiter 11 typischerweise aus einem gestanzten Metallrahmen gebildet wird, unterliegt seine Breite W herstellungsbedingt gewissen Schwankungen, die im Bereich von einigen 10 µm bis zu 100 µm liegen können.

Aus den beiden Kriterien ergibt sich deshalb, dass die Magnetfeldsensoren 5 mit Vorteil so auf dem Halbleiterchip 4 platziert werden, dass sie sich grösstenteils im Bereich oberhalb der Seitenkante 12 bzw. 13 und auf der Innenseite der jeweiligen Seitenkante, d.h. auf der dem Zentrum des Stromleiters 11 zugewandten Seite der jeweiligen Seitenkante, befinden. Die als Magnetfeldsensoren 5 bevorzugt eingesetzten horizontalen Hallelemente sind typischerweise quadratisch oder kreuzförmig und haben ein durch ihre Form gegebenes Symmetriezentrum. Man kann deshalb den optimalen Abstand der Magnetfeldsensoren 5 dadurch charakterisieren, dass der Abstand A zwischen den Symmetriezentren der beiden Magnetfeldsensoren 5 im Bereich von 0.9∗W ≤ A ≤ W liegt, wobei W die Breite des Stromleiters 11 im Bereich der Magnetfeldsensoren 5 bezeichnet.

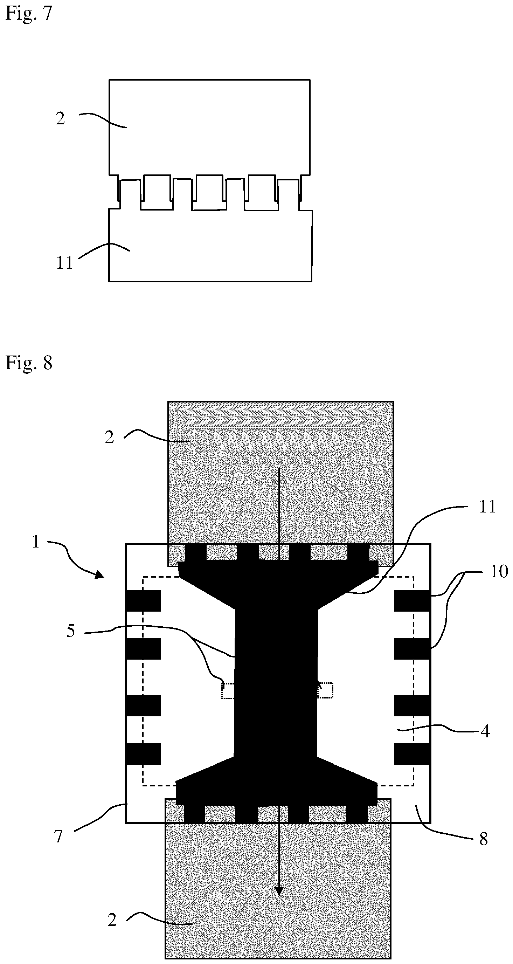

Die Fig. 7 zeigt in Aufsicht das eine Ende der Leiterbahn 2, das mit dem einen Ende des Stromleiters 11 überlappt, gemäss einer bevorzugten Ausführung. Die beiden Enden sind zahnförmig mit überlappenden Zähnen ausgebildet, damit beim Verlöten des Stromsensors 1 mit der Leiterplatte 3 einwandfreie Lotverbindungen entstehen.

Bei den in den Fig. 1 und 3 dargestellten Ausführungsbeispielen ist der Stromleiter 11 an seinen gegenüberliegenden Enden, an denen er mit der Leiterbahn 2 in Kontakt ist, als ein durchgehender Kontaktstreifen ausgebildet, der sich soweit dies fertigungstechnisch möglich ist, vollständig oder zumindest vorwiegend über die ganze Breite des Gehäuses 7 erstreckt. Die Fig. 8 zeigt ein weiteres Ausführungsbeispiel, bei dem der Stromleiter 11 an seinen gegenüberliegenden Enden, an denen er mit der Leiterbahn 2 in Kontakt ist, mit Anschlussfingern ausgebildet ist, die in gleicher Weise wie die elektrischen Anschlüsse 10 ausgebildet sind. Dies ermöglicht die Herstellung des Stromsensors auf eine Weise, die keine Anpassungen an die Technologie benötigt.

## Patentansprüche

1. Stromsensor (1), umfassend
ein flaches Gehäuse (7) aus Kunststoff mit einer Unterseite (8), einer Oberseite (9) und vier Seitenwänden, elektrischen Anschlüssen (10) und einem flachen Stromleiter (11), durch den ein zu messender Strom fliesst, wobei der flache Stromleiter (11) einen Abschnitt mit zwei geraden Seitenkanten (12, 13) aufweist, wobei der zu messende Strom im Abschnitt in gerader und parallel zu den Seitenkanten (12, 13) verlaufender Richtung fliesst,
einen Halbleiterchip (4) mit zwei Magnetfeldsensoren (5), wobei die beiden Magnetfeldsensoren (5) im Bereich oberhalb oder unterhalb der Seitenkanten (12, 13) des Abschnitts des Stromleiters (11) angeordnet sind, wo die von den beiden Magnetfeldsensoren (5) erfasste Komponente des Magnetfeldes an den Orten der beiden Magnetfeldsensoren (5) in entgegengesetzte Richtungen zeigt, **dadurch gekennzeichnet, dass** die beiden Magnetfeldsensoren (5) zwischen den Seitenkanten (12, 13) des Abschnitts des Stromleiters (11) auf der dem Zentrum des Stromleiters (11) zugewandten Seite der jeweiligen Seitenkante (12, 13) angeordnet sind.

2. Stromsensor nach Anspruch 1, **dadurch gekennzeichnet, dass** ein Abstand A zwischen Symmetriezentren der Magnetfeldsensoren (5) im Bereich von A ≥ 0.9∗W liegt, wobei W die Breite des Stromleiters (11) im Bereich der Magnetfeldsensoren (5) bezeichnet.

## Claims

1. A current sensor (1), comprising
a flat housing (7) of plastic having a lower side (8), an upper side (9), and four side walls, electrical terminals (10), and a flat conductor (11), through which a current to be measured flows, wherein the flat conductor (11) includes a section having two straight side edges (12, 13), wherein the current to be measured flows in the section in the direction extending straight and in parallel to the side edges (12, 13),
a semiconductor chip (4) having two magnetic field sensors (5), wherein the two magnetic field sensors (5) are arranged in the region above or below the side edges (12, 13) of the section of the conductor (11), where the component of the magnetic field detected by the two magnetic field sensors (5) points in opposite directions at the locations of the two magnetic field sensors (5),
**characterized in that** the two magnetic field sensors (5) are arranged between the side edges (12, 13) of the section of the conductor (11) on the side of the respective side edge (12, 13) facing toward the center of the conductor (11).

2. The current sensor as claimed in claim 1,
**characterized in that** the distance A between centers of symmetry of the magnetic field sensors (5) is in the range of A ≥ 0.9^{∗}W, wherein W designates the width of the conductor (11) in the region of the magnetic field sensors (5).

## Revendications

1. Capteur de courant (1), comprenant
un boîtier plat (7) en matière plastique avec un côté inférieur (8), un côté supérieur (9) et quatre parois latérales, des connexions électriques (10) et un conducteur de courant plat (11) parcouru par un courant à mesurer, dans lequel le conducteur de courant plat (11) présente une section avec deux bords latéraux rectilignes (12, 13), dans lequel le courant à mesurer circule dans la section dans une direction rectiligne et parallèle aux bords latéraux (12, 13),
une puce semi-conductrice (4) avec deux capteurs de champ magnétique (5), dans lequel les deux capteurs de champ magnétique (5) sont disposés dans la zone au-dessus ou en dessous des bords latéraux (12, 13) de la section du conducteur de courant (11) où la composante du champ magnétique détectée par les deux capteurs de champ magnétique (5) pointe dans des directions opposées au niveau des emplacements des deux capteurs de champ magnétique (5),
**caractérisé en ce que** les deux capteurs de champ magnétique (5) sont disposés entre les bords latéraux (12, 13) de la section du conducteur de courant (11) sur le côté du bord latéral respectif (12, 13) orienté vers le centre du conducteur de courant (11).

2. Capteur de courant selon la revendication 1,
**caractérisé en ce qu'**une distance A entre les centres de symétrie des capteurs de champ magnétique (5) se situe dans la plage A ≥ 0,9^{∗}W, dans lequel W désigne la largeur du conducteur de courant (11) dans la zone des capteurs de champ magnétique (5).
